# EUROPEAN PATENT SPECIFICATION

(11) **EP 3 921 157 B1**
(45) Date of publication and mention of the grant of the patent: **16.07.2025**
(21) Application number: 20704092.4
(22) Date of filing: 05.02.2020
(51) Int. Cl.: B32B 37/18, B29C 65/34, B32B 27/06, B32B 15/14, B32B 15/09, B32B 41/00, B32B 15/18, B32B 15/20, B32B 37/00, B32B 37/06, B32B 38/00, H05K 3/02, B32B 38/18, H05K 1/03

(54) **PROCESS FOR PREPARING MULTI-MATERIAL LAMINATES**
VERFAHREN ZUR HERSTELLUNG VON LAMINATEN AUS MEHREREN MATERIALIEN
PROCÉDÉ DE PRÉPARATION DE STRATIFIÉS MULTI-MATÉRIAUX

(30) Priority: 06.02.2019 IT 201900001739
(43) Date of publication of application: 15.12.2021
(73) Proprietor: Cedatec S.r.l., 21020 Daverio (VA) (IT)
(72) Inventor: COLOMBO, Mauro, 21028 Travedona-Monate (VA) (IT); RUNCHINA, Maurizio, 21040 Lozza (VA) (IT)
(74) Representative: De Ros, Alberto
(86) International application number: PCT/IB2020/050921
(87) International publication number: WO 2020/161641

(56) References cited:
- WO-A1-2013/121450
- WO-A1-2016/009455
- WO-A1-93/22139
- CN-A- 103 974 544
- JP-B2- 2 906 292
- US-A- 5 688 352

## Description

The present invention relates to a process for preparing multi-material laminates for printed circuit boards that comprises the formation of a stack of plastic laminates, indicated below as "packages", separated by plates of electrically insulating material, and the heating of the stack in the presence of at least two temperature detectors that allow the uniformity of the temperature to be obtained along the whole stack, and a system for realising said laminates.

The printed circuit boards for electronic components are commonly produced starting from plastic laminates comprising at least one metal lamina.

Within the context of the present invention, the individual packages are comprised of the alternation of sheets of variously metallized dielectric material ("inner layer") and sheets of pre-impregnated and partially polymerized plastic material (pre-preg). The first and last layer of every package are comprised of portions of a strip of copper or of an analogous metallic material able to conduct electricity.

Italian patent No. 0001255128 relates to a process for producing plastic laminates with metal plates, especially for printed circuit boards, performed by means of a column hydraulic press of descending type whose support surface and pressure surface are not heated. The process described in the mentioned patent consists of the formation of a stack of packs, each comprising a group of support sheets impregnated with partially polymerized plastic material ("pre-preg") and metal plates on one or both faces, characterized in that the metal plates are obtained from a continuous strip arranged at the lower face of the first group of sheets, starting from the bottom, and then after a 180° fold, arranged on the upper face of such group, and after the interposition of a metal plate duly insulated through the interposition of sheets of Kraft paper, after a second 180° fold in reverse direction with respect to the first, arranged at the lower face of the second group of sheets and after a third 180° fold in reverse direction with respect to the second fold, arranged on the upper face of this second group of sheets and so on up to the upper face of the latter group of sheets. After completing the formation of the stack of packs, the two ends of the strip are connected to an electric current generator with suitable power, in a manner such that by generating a suitable pressure on the stack of packs, the electric circuit of the generator closed, the various sections of the strip mating with the faces behave like electrical resistors, generating the necessary heat to lead to the melting of the plastic material impregnating the supporting sheets, so as to obtain the close connection (i.e. almost irreversible welding) between the various elements and the formation of the plastic laminates.

By way of non-limiting example, the strip may be made of copper, the metal plates interposed between the various packs may be made of stainless steel and each pack may be comprised of sheets made of glass fibre fabric, impregnated with epoxy resin. The stack of packs, including the copper strip folded as a coil around the separator plates, is placed between two containment plates, placed in contact with the lower face and the upper face, respectively, maintained aligned, for example, by two vertical cylinder rods.

The use of a copper strip wound as a coil, in which heating current circulates as indicated above, generates heat directly within the stack of material, allowing a more uniform heat distribution with respect to that allowed by the multi-surface presses, in which only the packs at the two ends of the stack are in contact with the heating surfaces.

The process that uses the copper strip for heating the packs is not free from drawbacks: the packs at the ends of the stack are colder with respect to those positioned at the centre of the stack and this difference increases as the total height of the stack itself increases, consequently the packs at the end of the stack must be discarded. The lower peripheral heating is due to the fact that the end packs benefit to a lesser extent from the thermal mass generated around the packs positioned at the centre of the stack.

A further disadvantage consists of the use of sheets of Kraft paper for insulating the separator sheets, with the consequent increase in times for preparing the stack of packs. The systematic use of sheets of Kraft paper also slows down the increase in temperature of the stack.

Another example of a prior art process is disclosed in WO 2013/121450 A1.

An object of the present invention is therefore to provide a method for preparing multilayer plastic laminates for printed circuit boards, substantially free from the disadvantages of the methods illustrated above and, in particular, able to produce laminates adapted for realizing printed circuit boards in a uniform way, minimizing the number of laminates discarded.

The subject matter of the present invention is a process for preparing plastic laminates according to claim 1.

The subject matter of the present invention is also a system for preparing plastic laminates according to claim 9.

Further characteristics and advantages of the present invention will be more evident from the following description of some preferred embodiments thereof, with reference to the appended drawings.

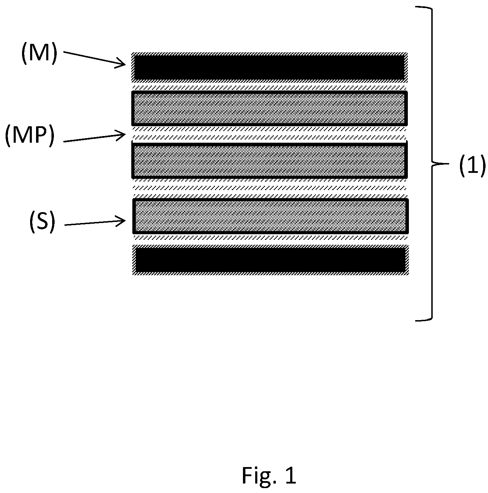

Figure 1 shows a "package" comprising layers of a dielectric material (S) impregnated with a polymeric material (MP) and two laminae of metallic electrically conductive material (M), one on each of the sides of the package.

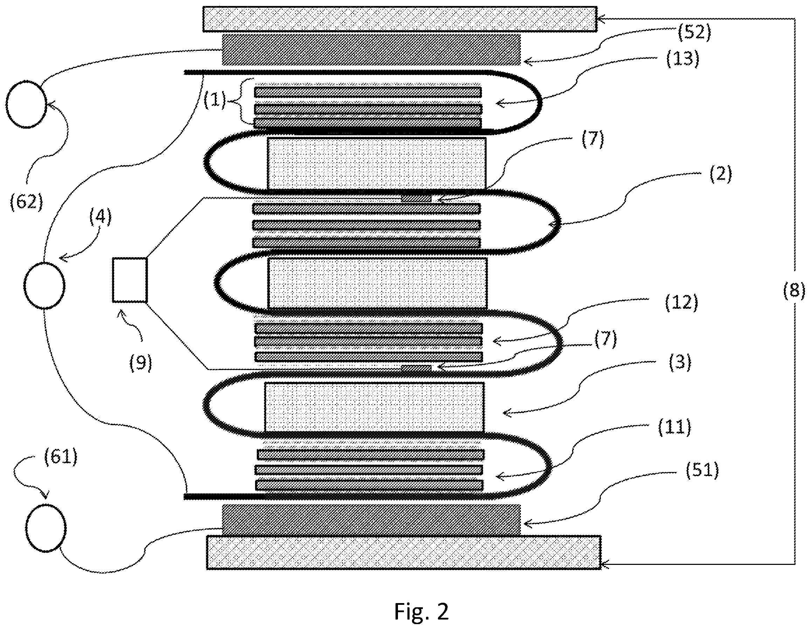

Figure 2 shows a system for preparing multilayer plastic laminates comprising at least two metallic laminae, adapted for the production of printed circuit boards comprising temperature probes according to the present invention, with the numbering followed below.
Figure 3 shows graphs of the temperatures detected along the stack in the case of absence of peripheral heating, of the presence of two heaters and only two probes placed at the ends of the stack and according to the invention (with 4 probes arranged as described above). The arrows indicate the position of the probes present.

The term "air bag" in the context of the present invention, means a device in which the pressure is applied to an air cushion made of synthetic rubber based on chlorosulfonated polyethylene (Hypalon^{®}), or another polymeric material, and silicone. The diaphragm exerts pressure on a pressure piston which, in turn, transfers the force onto the package of laminates to be pressed. The tank for the provision of air is connected to the press through an electronically controlled servo valve. The computer calculates the amount of air that is to be applied in order to reach the pressure programmed in the pressing cycle.

Unless otherwise indicated, within the context of the present invention the percentages and quantities of a component in a mixture relate to the weight of such component with respect to the total weight of the mixture.

Unless otherwise specified, within the context of the present invention the indication that a composition "comprises" one or more components or substances means that other components or substances may be present in addition to the one, or ones, specifically indicated.

Unless otherwise specified, within the context of the present invention a range of values indicated for a magnitude, e.g. the content by weight of a component, includes the lower limit and the upper limit of the range. For example, if the content by weight or by volume of a component A is indicated as "from X to Y", where X and Y are numerical values, A may be X or Y or any one of the intermediate values.

The inventors have surprisingly found that, thanks to the temperature control within the stack, obtained through at least two or more probes (7), which are placed within the stack in a position such as to be separated from the heating plates (61) and (62) by no less than one packet (1), it is possible to obtain fundamentally uniform packages, in this way, minimizing the number of multilayer plastic laminates to be discarded.

In the method according to the invention, after initial heat transfer, the combined action of the main generator and of the two auxiliary heaters makes sure that the temperature measured within the stack through the probes is fundamentally uniform from the start of the polymerization of the resin in the pre-preg, allowing a polymerization to be obtained and subsequent cross-linking of the uniform resin in all the packages of the stack.

In the method according to the invention, the upper and lower heating plates (51) and (52) are activated in synergy with the main generator in order to obtain the most uniform temperatures among the probes placed within the stack of packages, regardless of the effective temperature reached by the auxiliary heaters. The temperature of the upper heating plate (52) and that of the lower heating plate (51) are not controlled.

The method is applicable for the production of individual laminates, i.e. those comprising only one layer of dielectric material metallized on both sides, and also for the production of laminates comprising one or more layer of dielectric material.

In a preferred embodiment, the polymeric material (MP) is an epoxy resin or a mixture containing at least one epoxy resin.

In a preferred embodiment, the dielectric material (S) comprises, or is constituted of, one or more layers of glass fibre, FR4, PFTE (Teflon^{®}), polyimide (Kapton^{®}), glass or mixtures thereof. More preferably, the dielectric material (S) comprises, or is comprised of, one or more layers of glass fibre. Optionally, other layers of dielectric material different from glass fibre may be present such as, by way of non-limiting example, rubber, glass or ceramic material.

The metallized multilayer plastic laminates obtained with the method according to the present invention can be used, directly or after appropriate treatments, in the subsequent perforating, masking and photoengraving processing of the circuit layout, removal of the excess copper, and metallization of the through holes.

In a preferred embodiment of the present invention, the method further comprises the steps of returning to the initial pressure and temperature conditions, once the heating step under pressure has been finalized and the cross-linking of the polymeric material has been obtained, cutting the metallic strip flush with the opposite sides of the stack from where it exits and dismantling the stack itself into the single packages thus metallized.

In a preferred embodiment of the present invention, the probes (7) are from 3 to 6, preferably 4, distributed along the whole height, of which at least two are placed within the stack in a position such as to be separated by the heating plates (61) and (62) by no less than one package (1), whose temperature detections determine, through a control unit (9), the action of the main generator (4) and of the two auxiliary heaters (51) and (52).

In a preferred embodiment of the present invention, the pressure is applied to the stack via a press, optionally under vacuum, or via placing the stack in an autoclave or in an air bag.

Typically, but without limitation, the pressure is exerted by means of an air chamber (otherwise known as "air bag") on the upper heater, or on the lower one, and is transmitted therefrom to the stack. The pressure during the work cycle varies by discrete steps until predetermined temperature values are reached.

In a preferred embodiment of the present invention, the cross-linking is carried out at 80-150°C and/or the laminates are formed at a pressure from 1 to 3 MPa. By way of non-limiting example, the cycle for the formation of laminates can envisage an interval between 80°C and 150°C wherein the temperature can increase to a speed between 2 and 6°/min with pressure from 10 to 30 Kg/cm² and a second interval at 180°C at the same pressure.

In a preferred embodiment of the present invention, the metallic material of the strip (2) is chosen between copper and aluminium and/or the material of the plate (3) is one of aluminium, titanium and steel, optionally coated with a layer of electrically insulating material.

Preferably the separator plate (3) is aluminium, appropriately anodized to obtain a surface layer of electrically insulating black oxide.

In an embodiment provided by way of non-limiting example, the current supplied by the main power generator crosses the metallic casing of each auxiliary heater.

In an embodiment provided by way of non-limiting example, the portion of strip wound as a coil at the base of the stack rests on an extractable metallic tray, crossed by the current supplied by the main power generator and heated by the auxiliary electric heater on which it rests.

By way of non-limiting example, the loops of the copper strip formed at the ends of the stack can include in sequence, starting from the copper strip, an amortizing buffer layer and a separator plate.

In a preferred embodiment of the present invention, the temperature is controlled via a control unit (9), that is a programmable logic controller (PLC) through a computer so as to obtain a substantially uniform temperature throughout all the stack and, optionally, to heat the stack gradually according to a preset mode through appropriate control laws.

In a preferred embodiment of the present invention, in the process the current administered by the primary generator (4) has an intensity from 250 to 4000 A and the voltage produced by the secondary generators (61) and (62) is from 110 to 220 V

Preferably, the process of the present invention envisages further steps in which the packages (1) formed are subjected to the cutting of the excess metallic parts and then, optionally, to the manual cutting and separation of the individual packages to be sent to the subsequent trimming step.

A further aspect of the present invention is a system for preparing plastic laminates, which comprise at least two metallic laminae, suitable for the production of printed circuit boards, comprising at least one stack of two or more packages (1), wherein each package (1) comprises one or more support sheets, independently from the others, if present, comprises a dielectric material (S) impregnated with at least one polymeric material (MP) and two laminae of metallic electrically conductive material (M), one on each of the packages sides, wherein the metallic laminae are obtained starting from a continuous strip (2), wherein one end of the continuous strip (2) is placed at the lower side of the first support sheet, or group of support sheets (11) at the bottom part of the stack and the strip is bent so that, after a 180° bend, the strip is placed on the upper side of said sheet or group of sheets and, after positioning a plate (3) between the first package (11) and the package (12) above it, the strip is bent at 180°C in the direction opposite to the first bend and so as to be placed in contact with the lower side of the sheet or group of sheets (12), then the strip is bent again at 180° in the direction opposite to the previous bend so as to be placed on the upper side of the second sheet or group of sheets and the bending of the strip as above described is repeated until the other end of the strip is placed on the upper side of the sheet or group of sheets of the package (13) at the top of the stack, wherein the two strip are connected to a main power generator (4), which can supply a power suitable to obtain, once the electric circuit of the power generator (4) is closed, the heating of the strip to at a temperature T such as to cross-link the polymeric material (MP), so as to obtain, after applying on the stack a pressure suitable to cause mutual adhesion of the packages (1) separated by the plate (3), the bonding of the layers one another and with the portions of metal strip positioned close to the layers, to obtain packages (1) in the form of laminates, wherein the plate (3) is a plate made of metal or of another material, which conducts the heat without warping at the maximum temperature obtained during heating of the stack as described above, and two heating plates (51) and (52) are placed, respectively, under the lower layer and above the upper layer of the stack and provide heat to the ends of the stack by connection to two secondary power generators, respectively (61) and (62); and characterized in that:
- inside the stack two or more internal temperature probes (7) are present, which are placed so as to be separated from the heating plates (51) and (52) by not less than a package (1); and
- a control unit (9) is present, connected to the probes (7) and suitable to control, preferably by turning on and off, the main power generator (4) and/or the secondary power generators (61) and (62) so as to obtain cross-linking of the polymeric material (MP), resulting in the formation of packages (1), in a uniform way in all the layers of the stack; and
- means (8) of exerting pressure on said stack of two or more packages (1) is present, preferably selected from a double-layer press, optionally under vacuum, and an air bag.

In one aspect, the present invention relates to an apparatus for producing multilayer plastic laminates for printed circuit boards, comprising:
- first and second means arranged to cooperate so as to exert pressure on a stack of packages each composed of layers of conductive material and insulating material when said stack is placed between them,
- a first electric heating plate and a second electric heating plate associated, respectively, with said first and second means,
- a main power generator arranged to be connected to a conductive strip, which develops inside said stack,
- two secondary power generators connected to said heating plates,
- two or more temperature probes arranged to be inserted inside said stack and outside said electric heating plates, and so as to be separated from the electric heating plates by at least one package, and adapted to detect internal temperatures of the stack,
- a control unit arranged to drive said main power generator and said secondary power generators as a function of the signals received from said two or more probes so as to obtain a substantially uniform temperature throughout the whole stack (i.e. substantially the same temperature in all the zones of the stack regardless of their position). "Substantially uniform" typically and reasonably means that the temperature difference with respect to an average temperature varies from point to point in the interval +/- 5°C.

Preferably, the control unit is adapted to drive said main power generator and the secondary power generators as a function of signals received from the two or more probes so as to heat the stack gradually and uniformly; i.e. it is preferable for the temperature in the stack to be uniform not only during the "cooking" or "curing" of the stack, but also moment by moment during the heating of the stack and, possibly, moment by moment during the cooling of the stack.

Typically, the control unit implements (e.g. through an own internal pre-setting or an own internal software or firmware thereof if it is a programmed control unit) at least one driving law as a function of one or more of all the temperatures detected in zones internal to the stack; this could apply to the driving of the conductive strip. In particular, the control unit can implement two or three driving laws, each as a function of one or more or all of the temperatures detected in zones internal to the stack; this could apply to the driving of the conductive strip and of the two electric heating plates.

Preferably, said apparatus comprises three, or four, or five temperature probes, more preferably four temperature probes.

In the following example, provided to illustrate an embodiment of the invention, without limiting the aim thereof, four probes are positioned for detecting the temperature, distributed uniformly on the extension of the stack, of which at least two are placed within the stack in a position such as to be separated by the heating plates (51) and (52) by no less than one package (1), whose temperature detections determine, through a control unit (9), the action of the main generator (4) and of the two secondary power generators (61) and (62).

Thanks to the heat produced and their thermal isolation towards the cold surfaces of the press, the two additional heaters create a barrier against the dispersion of heat generated within the stack. The packages closest to the two ends of the stack mainly benefit from the additional heat and this compensates for the lower heating that they would have because of their position; in addition to this, the positioning of the probes within the stack of packages, therefore without directly detecting the temperature of the supplementary heaters, determines better and more precise management of the thermal condition.

The presence of two supplementary heaters controlled to realize the same thermal profile managed by the central probe, in the absence of probes positioned according to the present invention, does not guarantee temperature uniformity along the whole stack and this aspect becomes clearer as the total height of the stack itself increases.

The positioning of the probes within the stack and the addition of a second probe in the central zone determines more accurate temperature control. Even if in the central and in the peripheral zone the temperature may be slightly higher than the one set and controlled by the probes, the temperature variation overall along the stack will be moderate and the final result will be that substantially uniform packages are obtained after cross-linking.

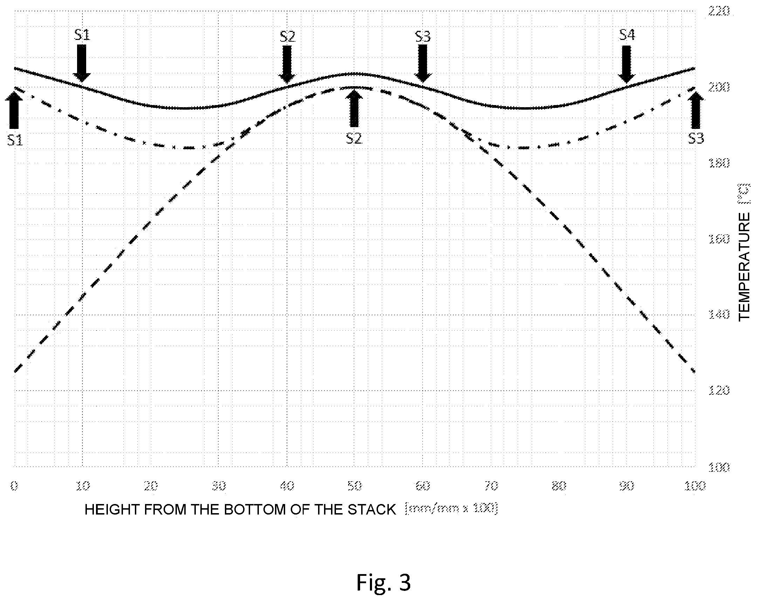

Figure 3 shows a comparison of the temperatures detected along the stack in the case of absence of peripheral heating, of the presence of two heaters and only two probes placed at the ends of the stack and according to the invention (with 4 probes arranged as described above). The arrows indicate the position of the probes present.

The broken line indicates the temperature profile obtained in the absence of heating plates.

The temperature profile indicated by a dash-dotted line is obtained in the presence of two heating plates placed at the upper end and at the lower end of the stack, with two probes positioned at the plates and a central probe.

The continuous line indicates the temperature profile obtained in the stack with 4 probes positioned according to the present invention.

It is possible to see how, in the configuration according to the present invention (continuous line), the temperature trend is substantially uniform throughout the extension of the stack. On the contrary, with another two configurations without intermediate probes the temperature varies significantly along the stack, causing lack of uniformity in the multilayer plastic laminates obtained in different points of the stack.

## Claims

1. A process for preparing plastic laminates, which comprise at least two metallic laminae, suitable for the production of printed circuit boards, wherein said process comprises the following steps:
- forming at least one stack of two or more plastic laminates, hereafter packages (1), wherein each package (1) comprises at least one support sheet, wherein each sheet, independently from the others, if present, comprises a dielectric material (S) impregnated with at least one polymeric material (MP) and two laminae of metallic electrically conductive material (M), one on each of the packages sides, wherein the laminae are obtained starting from a continuous strip (2), wherein one end of the continuous strip is placed at the lower side of the first support sheet, or group of support sheets (11) at the bottom part of the stack and the strip is bent so that, after a 180° bend, the strip is placed on the upper side of said sheet or group of sheets (11) and, after positioning a plate (3) between the first package (11) and the package (12) above it, the strip is bent at 180° in the direction opposite to the first bend and so as to be placed in contact with the lower side of the sheet or group of sheets (12), then the strip is bent again at 180° in the direction opposite to the previous bend so as to be placed on the upper side of the second sheet or group of sheets of the package (12) and the bending of the strip as above described is repeated until the other end of the strip is placed on the upper side of the sheet or group of sheets of the package (13) at the top of the stack, wherein the two ends of the strip are connected to a main power generator (4);
- heating the strip (2), as an effect of the electric current circulating in the strip (2), once the electric circuit of the power generator (4) is closed, at a temperature T such as to cross-link the polymeric material (MP), so as to obtain, after applying on the stack a pressure suitable to cause mutual adhesion of the packages (1) separated by the plate (3), the bonding of the layers one another and with the portions of metal strip positioned close to the layers, to obtain packages (1) in the form of laminates, wherein the plate (3) is a plate made of metal or of another material, which conducts the heat without warping at the maximum temperature obtained during heating of the stack as described above, and two heating plates (51, 52) are placed, respectively, under the lower layer and above the upper layer of the stack and provide heat to the ends of the stack by connection to two secondary power generators, respectively (61, 62); and **characterised in that**:
- the temperature inside the stack is detected via two or more probes (7), which are placed so as to be separated from the heating plates (51, 52) by not less than a package (1); and that
- said two or more probes (7) control, preferably by turning on and off, the main power generator (4) and the secondary power generators (61, 62) thanks to the temperature detected within the stack and therefore without directly detecting the temperature of the heating plates (51, 52) so as to obtain cross-linking of the polymeric material (MP), resulting in the formation of said laminates.

2. The process according to claim 1, wherein the pressure is applied to the stack via a press (8), optionally under vacuum, or via placing the stack in an autoclave or in an air bag.

3. The process according to claim 1 or 2, wherein the cross-linking is carried out at 80-150°C and/or the laminated are formed at a pressure from 1 to 3 MPa.

4. The process according to any one of the preceding claims, wherein the metallic material of the strip (2) is chosen between copper and aluminium and/or the material of the plate (3) is one of aluminium, titanium and steel, optionally coated with a layer of insulating material.

5. The process according to any one of the preceding claims, wherein the thickness of the single laminated packages obtained by the process is from 1 to 10 mm.

6. The process according to any one of the preceding claims, wherein the probes (7) are from three to six.

7. The process according to claim 6, wherein the probes (7) are four.

8. The process according to any one of the preceding claims, wherein the temperature is controlled via a control unit (9), that is a programmable logic controller (PLC), so as to obtain a substantially uniform temperature throughout all the stack and, optionally, to heat the stack gradually in a preset mode.

9. An apparatus for producing multilayer plastic laminates for printed circuit boards, comprising:
- first and second means (8) arranged to cooperate so as to exert pressure on a stack of packages (1) each composed of layers of conductive material (M) and insulating material (MP) when said stack is placed between them,
- a conductive strip (2), which develops inside said stack,
- a first electric heating plate (51) and a second electric heating plate (52) associated, respectively, with said first and second means (8),
- a main power generator (4) arranged to be connected to the conductive strip (2),
- two secondary power generators (61, 62) connected to said heating plates (51, 52);
- two or more temperature probes (7) arranged to be inserted inside said stack and outside said electric heating plates (51, 52) so as to be separated from the electric heating plates (51, 52) by at least one package (1), and adapted to detect internal temperatures of the stack;
and
- a control unit (9) arranged to drive said main power generator (4) and said secondary power generators (61, 62) on the basis of the inputs received from said two or more temperature probes (7) so as to obtain a substantially uniform temperature throughout the entire stack without directly detecting the temperature of the said heating plates (51, 52).

10. The apparatus according to claim 9, comprising three, or four, or five temperature probes.

11. The apparatus according to claim 9 or 10, wherein said control unit is adapted to drive said main power generator and said secondary power generators as a function of signals received from said two or more probes so as to heat the stack gradually and uniformly.

12. The apparatus according to claim 9, or 10, or 11, wherein said control unit implements at least one driving law as a function of one or more or all of the temperatures detected in zones internal to said stack.

13. The apparatus according to claim 12, wherein said control unit implements two or three driving laws, each as a function of one or more or all of the temperatures detected in zones internal to said stack.

## Patentansprüche

1. Verfahren zum Herstellen von Kunststofflaminaten, die mindestens zwei metallische Laminae umfassen, geeignet für die Produktion von Leiterplatten, wobei das Verfahren die folgenden Schritte umfasst:
- Ausbilden von mindestens einem Stapel aus zwei oder mehr Kunststofflaminaten, im Folgenden Pakete (1), wobei jedes Paket (1) mindestens eine Trägerbahn umfasst, wobei jede Bahn, unabhängig von den anderen, falls vorhanden, ein dielektrisches Material (S), imprägniert mit mindestens einem Polymermaterial (MP), und zwei Laminae aus metallischem, elektrisch leitfähigem Material (M) umfasst, eine auf jeder Seite der Pakete, wobei die Laminae ausgehend von einem kontinuierlichen Streifen (2) erhalten werden, wobei ein Ende des kontinuierlichen Streifens an der Unterseite der ersten Trägerbahn oder der Gruppe von Trägerbahnen (11) an dem Bodenteil des Stapels platziert wird und der Streifen gebogen ist, sodass der Streifen nach einer Biegung um 180° auf der Oberseite der Bahn oder der Gruppe von Bahnen (11) platziert wird, und nachdem eine Platte (3) zwischen dem ersten Paket (11) und dem darüber liegenden Paket (12) positioniert wird, der Streifen um 180° in die entgegengesetzte Richtung zu der ersten Biegung gebogen wird, sodass er in Kontakt mit der Unterseite der Bahn oder der Gruppe von Bahnen (12) steht, dann der Streifen erneut um 180° in die entgegengesetzte Richtung zu der vorherigen Biegung gebogen wird, um auf der Oberseite der zweiten Bahn oder der Gruppe von Bahnen des Pakets (12) platziert zu werden und das Biegen des Streifens wie oben beschrieben wiederholt wird, bis das andere Ende des Streifens auf der Oberseite der Bahn oder der Gruppe von Bahnen des Pakets (13) an dem Oberen des Stapels platziert ist, wobei die zwei Enden des Streifens mit einem Hauptleistungsgenerator (4) verbunden sind;
- Erhitzen des Streifens (2) infolge des in dem Streifen (2) fließenden elektrischen Stroms, sobald der Stromkreis des Leistungsgenerators (4) geschlossen ist, auf eine Temperatur T, um das Polymermaterial (MP) zu vernetzen, um nach einem Aufbringen eines Drucks auf den Stapel, geeignet, um eine gegenseitige Haftung der durch die Platte (3) getrennten Pakete (1) zu bewirken, die Bindung der Schichten miteinander und mit den in der Nähe der Schichten positionierten Abschnitten des Metallstreifens zu erhalten, um Pakete (1) in der Form von Laminaten zu erhalten, wobei die Platte (3) eine Platte ist, die aus Metall oder einem anderen Material hergestellt ist, das die Wärme leitet, ohne sich bei der bei dem Erhitzen des Stapels wie oben beschrieben erhaltenen Maximaltemperatur zu verziehen, und zwei Heizplatten (51, 52) jeweils unter der unteren Schicht und über der oberen Schicht des Stapels platziert sind und die Enden des Stapels durch eine Verbindung jeweils mit zwei sekundären Leistungsgeneratoren (61, 62) mit Wärme versorgen; und **dadurch gekennzeichnet, dass:**
- die Temperatur im Inneren des Stapels über zwei oder mehr Sonden (7) erfasst wird, die platziert sind, um von den Heizplatten (51, 52) durch nicht weniger als ein Paket (1) getrennt zu sein; und dass
- die zwei oder mehr Sonden (7), vorzugsweise durch ein Ein- und Ausschalten, den Hauptleistungsgenerator (4) und die sekundären Leistungsgeneratoren (61, 62) dank der innerhalb des Stapels erfassten Temperatur und daher ohne direktes Erfassen der Temperatur der Heizplatten (51, 52) steuern, um eine Vernetzung des Polymermaterials (MP) zu erhalten, die zu der Ausbildung der Laminate führt.

2. Verfahren nach Anspruch 1, wobei der Druck auf den Stapel über eine Presse (8), optional unter Vakuum, oder über ein Platzieren des Stapels in einen Autoklaven oder in einen Airbag ausgeübt wird.

3. Verfahren nach Anspruch 1 oder 2, wobei die Vernetzung bei 80-150 °C durchgeführt wird und/oder die Laminate bei einem Druck von 1 bis 3 MPa ausgebildet werden.

4. Verfahren nach einem der vorstehenden Ansprüche, wobei das metallische Material des Streifens (2) aus Kupfer oder Aluminium gewählt ist und/oder das Material der Platte (3) eines von Aluminium, Titan und Stahl ist, optional beschichtet mit einer Schicht aus Isoliermaterial.

5. Verfahren nach einem der vorstehenden Ansprüche, wobei die Dicke der durch das Verfahren erhaltenen einzelnen laminierten Pakete von 1 bis 10 mm beträgt.

6. Verfahren nach einem der vorstehenden Ansprüche, wobei die Sonden (7) von drei bis sechs sind.

7. Verfahren nach Anspruch 6, wobei die Sonden (7) vier sind.

8. Verfahren nach einem der vorstehenden Ansprüche, wobei die Temperatur über eine Steuereinheit (9), das heißt eine speicherprogrammierbare Steuerung (SPS), gesteuert wird, um in dem gesamten Stapel eine im Wesentlichen gleichmäßige Temperatur zu erhalten und den Stapel optional in einem voreingestellten Modus allmählich zu erwärmen.

9. Vorrichtung zum Herstellen von mehrschichtigen Kunststofflaminaten für Leiterplatten, umfassend:
- erste und zweite Mittel (8), die angeordnet sind, um zusammenzuwirken, um Druck auf einen Stapel von Paketen (1) auszuüben, die jeweils aus Schichten aus leitfähigem Material (M) und isolierendem Material (MP) bestehen, wenn der Stapel zwischen ihnen platziert ist,
- einen leitfähigen Streifen (2), der sich innerhalb des Stapels formt,
- eine erste elektrische Heizplatte (51) und eine zweite elektrische Heizplatte (52), die jeweils dem ersten und dem zweiten Mittel (8) zugeordnet sind,
- einen Hauptleistungsgenerator (4), der angeordnet ist, um mit dem leitfähigen Streifen (2) verbunden zu werden,
- zwei sekundäre Leistungsgeneratoren (61, 62), die mit den Heizplatten (51, 52) verbunden sind;
- zwei oder mehr Temperatursonden (7), die angeordnet sind, um in den Stapel und außerhalb der elektrischen Heizplatten (51, 52) eingesetzt zu werden, um von den elektrischen Heizplatten (51, 52) durch mindestens ein Paket (1) getrennt zu sein, und angepasst, um Innentemperaturen des Stapels zu erfassen; und
- eine Steuereinheit (9), die angeordnet ist, um den Hauptleistungsgenerator (4) und die sekundären Leistungsgeneratoren (61, 62) auf der Grundlage der Eingaben anzutreiben, die von den zwei oder mehr Temperatursonden (7) empfangen werden, um in dem gesamten Stapel eine im Wesentlichen gleichmäßige Temperatur zu erhalten, ohne die Temperatur der Heizplatten (51, 52) direkt zu erfassen.

10. Vorrichtung nach Anspruch 9, umfassend drei oder vier oder fünf Temperatursonden.

11. Vorrichtung nach Anspruch 9 oder 10, wobei die Steuereinheit angepasst ist, um den Hauptleistungsgenerator und die sekundären Leistungsgeneratoren in Abhängigkeit der Signale anzutreiben, die von den zwei oder mehr Sonden empfangen werden, um den Stapel allmählich und gleichmäßig zu erhitzen.

12. Vorrichtung nach Anspruch 9, 10 oder 11, wobei die Steuereinheit mindestens ein Antriebsgesetz in Abhängigkeit von einer oder mehreren oder allen in den Zonen innerhalb des Stapels erfassten Temperaturen implementiert.

13. Vorrichtung nach Anspruch 12, wobei die Steuereinheit zwei oder drei Antriebsgesetze implementiert, jedes in Anhängigkeit von einer oder mehreren oder allen in den Zonen innerhalb des Stapels erfassten Temperaturen.

## Revendications

1. Procédé pour la préparation de plastiques stratifiés qui comprennent au moins deux lames métalliques, convenant à la production de cartes de circuits imprimés, dans lequel ledit procédé comprend les étapes suivantes :
- formation d'au moins un empilement de deux plastiques stratifiés ou plus, ci-après dénommés paquets (1), dans lequel chaque paquet (1) comprend au moins une feuille de support, dans lequel chaque feuille, indépendamment les unes des autres, si elles sont présentes, comprend un matériau diélectrique (S) imprégné d'au moins un matériau polymère (MP) et deux lames de matériau métallique conducteur d'électricité (M), une sur chaque côté des paquets, dans lequel les lames sont obtenues à partir d'une bande (2) continue, dans lequel une extrémité de la bande continue est placée au niveau du côté inférieur de la première feuille de support, ou du groupe de feuilles de support (11) au niveau de la partie inférieure de l'empilement et la bande est pliée de sorte que, après un pliage à 180°, la bande est placée sur le côté supérieur de ladite feuille ou dudit groupe de feuilles (11) et, après le positionnement d'une plaque (3) entre le premier paquet (11) et le paquet (12) au-dessus de lui, la bande est pliée à 180° dans la direction opposée au premier pliage et de manière à être mise en contact avec le côté inférieur de la feuille ou du groupe de feuilles (12), puis la bande est à nouveau pliée à 180° dans la direction opposée au pliage précédent de manière à être placée sur le côté supérieur de la seconde feuille ou du groupe de feuilles du paquet (12) et le pliage de la bande tel que décrit ci-dessus est répété jusqu'à ce que l'autre extrémité de la bande soit placée sur le côté supérieur de la feuille ou du groupe de feuilles du paquet (13) au sommet de l'empilement, dans lequel les deux extrémités de la bande sont connectées à un générateur d'énergie principal (4) ;
- chauffage de la bande (2), sous un effet du courant électrique circulant dans la bande (2) une fois que le circuit électrique du générateur d'énergie (4) est fermé, à une température T de manière à réticuler le matériau polymère (MP) de manière à obtenir, après l'application sur l'empilement d'une pression suffisante pour provoquer une adhésion mutuelle des paquets (1) séparés par la plaque (3), le collage des couches entre elles et avec les portions de bande métallique positionnées à proximité des couches, à obtenir des paquets (1) sous forme de stratifiés, dans lequel la plaque (3) est une plaque en métal ou en un autre matériau qui conduit la chaleur sans se déformer à la température maximale obtenue lors du chauffage de l'empilement tel que décrit ci-dessus, et deux plaques chauffantes (51, 52) sont placées respectivement sous la couche inférieure et au-dessus de la couche supérieure de l'empilement et fournissent de la chaleur aux extrémités de l'empilement en étant connectées à deux générateurs d'énergie secondaires, respectivement (61, 62) ; et **caractérisé en ce que :**
- la température à l'intérieur de l'empilement est détectée par l'intermédiaire de deux sondes (7) ou plus, lesquelles sont placées de manière à être séparées des plaques chauffantes (51, 52) par un minimum d'un paquet (1) ; et **en ce que**
- lesdites deux sondes (7) ou plus commandent, de préférence en l'activant et en le désactivant, le générateur d'énergie principal (4) et les générateurs d'énergie (61, 62) secondaires grâce à la température détectée à l'intérieur de l'empilement et donc sans détecter directement la température des plaques chauffantes (51, 52) de manière à obtenir la réticulation du matériau polymère (MP), aboutissant à la formation desdits stratifiés.

2. Procédé selon la revendication 1, dans lequel la pression est appliquée à l'empilement par l'intermédiaire d'une presse (8), éventuellement sous vide, ou par l'intermédiaire du placement de l'empilement dans un autoclave ou dans un coussin d'air.

3. Procédé selon la revendication 1 ou 2, dans lequel la réticulation est effectuée à 80 à 150 °C et/ou les stratifiés sont formés à une pression allant de 1 à 3 MPa.

4. Procédé selon l'une quelconque des revendications précédentes, dans lequel le matériau métallique de la bande (2) est choisi entre cuivre et aluminium et/ou le matériau de la plaque (3) est l'un parmi aluminium, titane et acier, éventuellement recouvert d'une couche de matériau isolant.

5. Procédé selon l'une quelconque des revendications précédentes, dans lequel l'épaisseur des paquets stratifiés simples obtenus par le procédé va de 1 à 10 mm.

6. Procédé selon l'une quelconque des revendications précédentes, dans lequel les sondes (7) sont au nombre de trois à six.

7. Procédé selon la revendication 6, dans lequel les sondes (7) sont au nombre de quatre.

8. Procédé selon l'une quelconque des revendications précédentes, dans lequel la température est commandée par l'intermédiaire d'une unité de commande (9), c'est-à-dire un contrôleur programmable (PLC), de manière à obtenir une température sensiblement uniforme dans l'ensemble de l'empilement et, éventuellement, à chauffer l'empilement progressivement dans un mode prédéfini.

9. Appareil pour la production de plastiques stratifiés multicouches pour des cartes de circuits imprimés, comprenant :
- un premier et un second moyen (8) conçus pour coopérer de manière à exercer une pression sur un empilement de paquets (1) composés chacun de couches de matériau conducteur (M) et de matériau isolant (MP) lorsque ledit empilement est placé entre eux,
- une bande (2) conductrice, laquelle se développe à l'intérieur dudit empilement,
- une première plaque chauffante (51) électrique et une seconde plaque chauffante (52) électrique associées respectivement auxdits premier et second moyens (8),
- un générateur d'énergie principal (4) configuré pour être connecté à la bande (2) conductrice,
- deux générateurs d'énergie (61, 62) secondaires connectés auxdites plaques chauffantes (51, 52) ;
- deux sondes de température (7) ou plus conçues pour être insérées à l'intérieur dudit empilement et à l'extérieur desdites plaques chauffantes (51, 52) électriques de manière à être séparées des plaques chauffantes (51, 52) électriques par au moins un paquet (1), et configurées pour détecter des températures internes de l'empilement ; et
- une unité de commande (9) configurée pour piloter ledit générateur d'énergie principal (4) et lesdits générateurs d'énergie (61, 62) secondaires sur la base des entrées reçues desdites deux sondes de température (7) ou plus, de manière à obtenir une température sensiblement uniforme dans l'ensemble de l'empilement sans détecter directement la température desdites plaques chauffantes (51, 52).

10. Appareil selon la revendication 9, comprenant trois, ou quatre ou cinq sondes de température.

11. Appareil selon la revendication 9 ou 10, dans lequel ladite unité de commande est configurée pour piloter ledit générateur d'énergie principal et lesdits générateurs d'énergie secondaires en fonction de signaux reçus desdits deux sondes ou plus de manière à chauffer l'empilement progressivement et uniformément.

12. Appareil selon la revendication 9, ou 10, ou 11, dans lequel ladite unité de commande met en œuvre au moins une loi de pilotage en fonction d'une ou de plusieurs ou de toutes les températures détectées dans des zones internes audit empilement.

13. Appareil selon la revendication 12, dans lequel ladite unité de commande met en œuvre deux ou trois lois de pilotage, chacune en fonction d'une ou de plusieurs ou de toutes les températures détectées dans des zones internes audit empilement.
